# EUROPEAN PATENT APPLICATION

(11) **EP 3 576 162 A1**
(43) Date of publication of application: **04.12.2019**
(21) Application number: 18202367.1
(22) Date of filing: 24.10.2018
(51) Int. Cl.: H01L 31/048, B29B 17/02, H01L 31/0392

(54) **METHOD FOR SEPARATING AN ORGANIC FILM OF A SOLAR CELL MODULE AND METHOD FOR RECYCLING**

(30) Priority: 01.06.2018 CN 201810556025
(71) Applicant: Hanergy New Material Technology Co., Ltd., Yanqi Industrial Development Zone Huairou District Beijing 101407 (CN)
(72) Inventor: SUN, Gang, Beijing, 101407 (CN); LI, Shengchun, Beijing, 101407 (CN); TAN, Mingliang, Beijing, 101407 (CN)
(74) Representative: Nordmeyer, Philipp Werner

(57) **Abstract**

The present disclosure provides a method for separation of an organic film from a solar cell module, the separation method including the following steps: treating the solar cell module by a heat treatment in combination with a ultrasonic treatment; and performing separation of the treated solar cell module by buoyancy, thereby achieving the separation of the organic film from the module. The present disclosure uses the heat treatment in combination with the ultrasonic treatment to separate the organic film of the solar cell module, so that a stripping rate of the solar cell module reaches 97% or more, and the organic film after detachment does not adhere to the active material, the active material layer remains intact, the surface is clean and has no gelatin spots, and a loss rate is 1% or less, and thus the method is efficient, convenient, and easy to industrialize.

## Description

### TECHNICAL FIELD

The present disclosure relates to the field of solar cell, particularly to a separation method of an organic film module of a solar cell module and a recycling method of a solar cell module.

### BACKGROUND

With a rapid development of the solar cell industry, a total output of solar modules has also increased rapidly. However, as a service time of solar cells increases, it can be inferred that in the near future, a large number of photovoltaic modules will be scrapped in accordance with the service life of the solar photovoltaic modules, and in the production process of the solar modules, there will also generate defective products. Therefore, a problem of recycling solar module has been put on an agenda.

However, in the art, the recycling of solar organic film modules is still a difficult problem to be solved.

### SUMMARY

The present disclosure provides a separation method of an organic film of a solar cell module, including the following steps:
treating the solar cell module by heat treatment in combination with a ultrasonic treatment, and performing separation of the treated solar cell module by buoyancy, thereby achieving separation of the organic film from the module.

Optionally, the heat treatment is performed at a temperature of 80 to 300 °C, such as 80 °C, 90 °C, 95 °C, 100 °C, 105 °C, 110 °C, 120 °C, 130 °C, 140 °C, 150 °C, 160 °C, 170 °C, 180 °C, 200 °C, 230 °C, 250 °C, 280 °C or 300 °C, preferably 100 to 180 °C.

Optionally, a duration time for the heat treatment is 5 to 60 min, such as 5 min, 8 min, 10 min, 15 min, 20 min, 25 min, 30 min, 35 min, 40 min, 45 min, 50 min, 55 min or 60 min, preferably 15 to 40 min.

Optionally, the ultrasonic frequency of the ultrasonic treatment is 20 to 40 KHz, such as 20 KHz, 22 KHz, 24 KHz, 26 KHz, 28 KHz, 30 KHz, 32 KHz, 35 KHz, 38 KHz or 40 KHz.

Optionally, a duration time for the ultrasonic treatment is 10 to 120 min, such as 10 min, 15 min, 20 min, 25 min, 30 min, 40 min, 50 min, 60 min, 80 min, 100 min or 120 min.

Optionally, the heat treatment is a microwave heat treatment, a muffle furnace heat treatment, an induction cooker heat treatment or an electric furnace heat treatment, preferably a microwave heat treatment.

Optionally, the ultrasonic treatment is a water bath ultrasonic treatment.

Optionally, one or more inorganic salt chemical agents may be added to the water in water bath ultrasonic treatment in order to increase an efficiency of a film stripping. Optionally, the inorganic salt is selected from one or more of basic inorganic salts, neutral inorganic salts, etc., such as sodium hydroxide, potassium hydroxide, calcium hydroxide, calcium oxide, magnesium hydroxide, magnesium oxide, sodium carbonate, potassium carbonate, sodium sulfate, potassium sulfate, sodium chloride, potassium chloride, basic zinc carbonate, and sodium hypochlorite.

Optionally, the separation method comprises the steps of: treating the solar cell module by the microwave heat treatment in combination with water bath ultrasonic treatment, and separating the treated solar cell module by buoyancy, thereby achieving separation of the organic film from the module.

In the present disclosure, the microwave heat treatment in combination with the water bath ultrasonic treatment is performed by first performing the microwave heat treatment of the solar cell module, and then performing the water bath ultrasonic treatment of the solar cell module; or first performing the water bath ultrasonic treatment of the solar cell module, and then performing the microwave heat treatment of the solar cell module; preferably, first performing the microwave heat treatment of the solar cell module, and then performing the water bath ultrasonic treatment of the solar cell module.

Optionally, a temperature of the water bath during the water bath ultrasonic treatment is 50 to 100 °C, such as 50 °C, 55 °C, 60 °C, 65 °C, 70 °C, 75 °C, 80 °C, 85 °C, 90 °C, 95 °C or 100 °C.

Optionally, the water bath ultrasonic treatment is performed under stirring, and the stirring is performed at a rate of 20 to 150 r/min, such as 20 r/min, 25 r/min, 30 r/min, 35 r/min, 40 r/min, 45 r/min, 50 r/min, 55 r/min, 60 r/min, 70 r/min, 80 r/min, 100 r/min, 120 r/min, 140 r/min or 150 r/min.

Optionally, the stirring direction is changed after each stirring for 10-60 revolutions.

In the present disclosure, the separation by buoyancy is a separation by buoyancy performed in water.

In the present disclosure, the organic film may be various organic films, preferably an organic wire film, an organic water-blocking film or an organic encapsulating film.

In the present disclosure, a substrate of the solar cell module may be a stainless steel substrate, a glass-based substrate or a silicon-based substrate.

As an embodiment, the separation method of the organic film of the solar cell module of the present disclosure specifically includes the following steps:
(1) treating the solar cell module by the microwave heat treatment in combination with the water bath ultrasonic treatment, wherein the microwave heat treatment is performed at a temperature of 80 to 300 °C, a duration time for the heat treatment is 5 to 60 min, the water bath ultrasonic treatment is performed under stirring, the stirring is performed at a rate of 20 to 150 r/min, the temperature of the water bath is 50 to 100°C, the ultrasonic frequency is 20 to 40 KHz, the stirring direction is changed after each stirring for 10-60 revolutions, and the duration time for the water bath ultrasonic treatment is 10 to 120 min;
(2) after the treatment of the step (1) is completed, performing a separation by buoyancy in water, thereby separating the organic film from the module.

As a further embodiment, the separation method of the organic film module of the solar cell module of the present disclosure includes the following steps:
(1) subjecting the solar cell module to the microwave heat treatment at a temperature of 80 to 300 °C for 5 to 60 min;
(2) placing the solar cell module treated in the step (1) in a water bath of 50-100 °C, subjecting the solar cell module to the ultrasonic treatment for 10 to 120 min under stirring at a stirring rate of 20 to 150 r/min, changing the stirring direction after each stirring for 10-60 revolutions, wherein the ultrasonic frequency is 20-40 KHz;
(3) after the water bath ultrasonic treatment is finished, achieving separation of the organic film from the module by buoyancy in water.

The present disclosure also provides a recycling method of a solar cell module, including the above separation method.

Optionally, the above solar cell module is a flexible solar cell module.

Optionally, the recycling method further includes: after separating the organic film from the solar cell module, subjecting the remaining portion of the module to a leaching separation such that the substrate of the solar cell module is separated from an active material layer.

Optionally, in the above recycling method, the ultrasonic treatment is performed using the water bath ultrasonic treatment, then separation by buoyancy is performed using water in the water bath, and the leaching separation is performed directly using the water bath solution after the separation by buoyancy.

Optionally, in the above recycling method, a leaching agent is added to the leachate during the leaching separation.

Optionally, the leaching agent is a mixture of an acidic substance and a surface treatment agent.

Optionally, the acidic substance is selected from any one or more of sulfuric acid, hydrochloric acid, and nitric acid.

Optionally, the surface treatment agent is selected from any one or more of hydrogen peroxide, sodium hypochlorite, sodium peroxide, ozone, sodium nitrite, sodium phosphate, and corrosion inhibitor Lan826.

### BRIEF DESCRIPTION OF THE FIGURES

FIG. 1 is a schematic flow chart showing a separation method of the organic film of the solar cell module according to the present disclosure;
FIG. 2 is a schematic flow chart showing a separation method of the organic film of the solar cell module in Example 1 of the present disclosure;

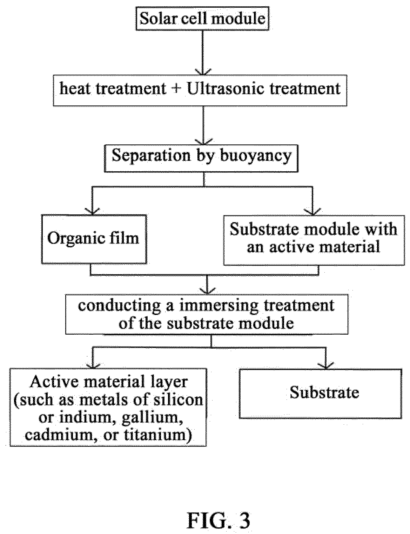

FIG. 3 is a schematic flow chart showing a recycling method of the solar cell module in some Examples of the present disclosure.

### DETAILED DESCRIPTION

The technical solutions of the present disclosure will be further described below by way of specific embodiments. It should be understood by those skilled in the art that the examples are only intended to facilitate the understanding of the present disclosure and are not to be considered as limiting.

A solar cell module generally includes a front plate, a back plate, an organic film layer (such as an organic encapsulating film, an organic wire film, an organic water-blocking film), and a substrate. A currently preferred solar cell module is a flexible solar module.

Metals such as silicon or indium, gallium, cadmium, and titanium commonly used in the flexible solar modules are very expensive, and some metals may cause great pollution to the environment if they are unreasonably recycled after the modules are scrapped. However, the flexible solar module is a multi-layer composite structure, and due to requirements of the solar module for weather resistance, water resistance, flame retardancy, etc., the front plate, the back plate and the encapsulating film layer contained in the solar module all have insoluble and refractory properties, which makes it difficult to separate them from the chip, thereby making recycling of expensive raw materials on the chip difficult.

There are three main methods for recycling the flexible solar organic film module. one method is calcination, that is, the entire photovoltaic module is calcined at a high temperature, and the remaining non-combustible portion is recycled. However, high-temperature calcination has high energy consumption, and fluorine, selenium and other elements in the photovoltaic sheets will produce toxic gases after incineration, which will seriously pollute the environment. Another method is to pulverize the flexible module and recover it by an acid-base leaching treatment. However, when the pulverization is performed, the stainless steel sheets are turned into iron filings powder, and a large amount of iron ion impurities are easily leached into the leaching liquid during the leaching step, which makes it difficult to carry out the subsequent wet recovery of elements such as indium and gallium. Further another method is to use a cryogenic treatment, but the cryogenic treatment requires liquid nitrogen, which is high in cost and difficult to achieve, and the photovoltaic sheet after the cryogenic treatment needs to be stripped by manual tapping and the like, and thus the method is not suitable for industrialization.

In order to solve the above problems, an object of the present disclosure is to provide a separation method of an organic film module of a solar cell module. The method of the present disclosure can achieve the separation of the organic film of the solar cell module, keep the organic film intact, and can keep the active material layer intact, clean and free of gelatin spots, and keep a loss rate small.

In one aspect, the present disclosure provides a separation method of an organic film of a solar cell module, the separation method including the following steps:
treating the solar cell module by a heat treatment in combination with a water bath ultrasonic treatment, and performing a separation of the treated solar cell module by buoyancy, thereby achieving a separation of the organic film from the module.

In the present disclosure, first, the heat treatment is used in combination with the ultrasonic treatment to increase a temperature of the semiconductor material bonded to the substrate in the solar cell module, and the ultrasonic treatment is combined to facilitate the separation of the organic film from the substrate of the module.

Optionally, the heat treatment is performed at a temperature of 80 to 300 °C, such as 80 °C, 90 °C, 95 °C, 100 °C, 105 °C, 110 °C, 120 °C, 130 °C, 140 °C, 150 °C, 160 °C, 170 °C, 180 °C, 200 °C, 230 °C, 250 °C, 280 °C or 300 °C, preferably 100 to 180 °C. Selecting a suitable heating temperature in the present disclosure can facilitate separation of the organic film from the substrate of the module, and can contribute to keeping the organic film and the active material layer intact. Too low a temperature may result in poor separation rate, while too high a temperature may cause damage to the organic film and the active material layer.

Optionally, the duration time for the heat treatment is 5 to 60 min, such as 5 min, 8 min, 10 min, 15 min, 20 min, 25 min, 30 min, 35 min, 40 min, 45 min, 50 min, 55 min or 60 min, preferably 15 to 40 min.

Optionally, a ultrasonic frequency of the ultrasonic treatment is 20 to 40 KHz, such as 20 KHz, 22 KHz, 24 KHz, 26 KHz, 28 KHz, 30 KHz, 32 KHz, 35 KHz, 38 KHz or 40 KHz. In the present disclosure, it is necessary to select an appropriate ultrasonic frequency for ultrasound. When the frequency of the ultrasonic treatment is too low, it may result in incomplete separation, and when the frequency of the ultrasonic treatment is too large, energy consumption is high and the active material layer is easily damaged.

Optionally, the duration time for the ultrasonic treatment is 10 to 120 min, such as 10 min, 15 min, 20 min, 25 min, 30 min, 40 min, 50 min, 60 min, 80 min, 100 min or 120 min.

Optionally, the heat treatment is a microwave heat treatment, a muffle furnace heat treatment, an induction cooker heat treatment or an electric furnace heat treatment, preferably a microwave heat treatment.

Optionally, the ultrasonic treatment is a water bath ultrasonic treatment.

Optionally, one or more inorganic salt chemical agents may be added to the water in water bath ultrasonic treatment in order to increase efficiency of a film stripping. Optionally, the inorganic salt is selected from one or more of basic inorganic salts, neutral inorganic salts, etc. such as sodium hydroxide, potassium hydroxide, calcium hydroxide, calcium oxide, magnesium hydroxide, magnesium oxide, sodium carbonate, potassium carbonate, sodium sulfate, potassium sulfate, sodium chloride, potassium chloride, basic zinc carbonate, and sodium hypochlorite.

Optionally, the separation method comprises the steps of: treating the solar cell module by the microwave heat treatment combination with the water bath ultrasonic treatment, and separating the treated solar cell module by buoyancy, thereby achieving the separation of the organic film from the module.

In the present disclosure, the combination of the microwave heat treatment and the water bath ultrasonic treatment may increase the temperature of the semiconductor material bonded to the substrate in the solar cell module, the organic film material in contact with the semiconductor material is uniformly heated and melted, and the ultrasonic treatment is combined to cause the organic film material to easily separate from the substrate, and can maintain an integrity of the organic film and the integrity and non-destruction of the active material layer.

In the present disclosure, the microwave heat treatment in combination with the water bath ultrasonic treatment is performed by first performing the microwave heat treatment of the solar cell module, and then performing the water bath ultrasonic treatment of the solar cell module; or first performing the water bath ultrasonic treatment of the solar cell module, and then performing the microwave heat treatment of the solar cell module; preferably, first performing the microwave heat treatment of the solar cell module, and then performing the water bath ultrasonic treatment of the solar cell module.

In the present disclosure, the microwave heat treatment has the advantage of uniformity and selectivity, and can break molecules of bonding the organic film and the substrate without destroying the module substrate (such as a steel sheet) and the active material layer.

Optionally, the temperature of water bath during the water bath ultrasonic treatment is 50 to 100 °C, such as 50 °C, 55 °C, 60 °C, 65 °C, 70 °C, 75 °C, 80 °C, 85 °C, 90 °C, 95 °C or 100 °C.

Optionally, the water bath ultrasonic treatment is performed under stirring, and the stirring is is performed at a rate of 20 to 150 r/min, such as 20 r/min, 25 r/min, 30 r/min, 35 r/min, 40 r/min, 45 r/min, 50 r/min, 55 r/min, 60 r/min, 70 r/min, 80 r/min, 100 r/min, 120 r/min, 140 r/min or 150 r/min.

Optionally, the stirring direction is changed after each stirring for 10-60 revolutions.

In the present disclosure, the separation by buoyancy is a separation by buoyancy performed in water.

In the present disclosure, the use of separation by buoyancy in water means that the lighter organic film layer in water can float in the water, while the heavier remaining portion of the module sinks to the bottom. After the separation by buoyancy in water, the organic film layer floating in the water can be removed by a colander, a hanging basket or a jig.

In the present disclosure, a recycling method of a solar cell module is also provided, and the recycling method may include not only the separation method as described above to recycle the organic film layer, but also include the treatment recycle of the remaining portion of the module from which the organic film is removed. For example, the substrate and the active material such as silicon or indium, gallium, cadmium, titanium, and the like are recycled.

Optionally, the above solar cell module is a flexible solar cell module.

Optionally, the recycling method further includes: after separating the organic film from the solar cell module, subjecting the remaining portion of the module to a leaching separation such that the substrate of the solar cell module is separated from the active material layer.

Optionally, in the above recycling method, the ultrasonic treatment was performed using the water bath ultrasonic treatment, then separation by buoyancy was performed using the water in the water bath, and the leaching separation was performed directly using the water bath solution after the separation by buoyancy.

Optionally, in the above recycling method, a leaching agent is added to the leachate during the leaching separation.

Optionally, the leaching agent is a mixture of an acidic substance and a surface treatment agent.

Optionally, the acidic substance is selected from any one or more of sulfuric acid, hydrochloric acid, and nitric acid.

Optionally, the surface treatment agent is selected from any one or more of hydrogen peroxide, sodium hypochlorite, sodium peroxide, ozone, sodium nitrite, sodium phosphate, and corrosion inhibitor Lan826.

In a specific aspect, upon the separation method of the present disclosure, the remaining portion of the module after the organic film is removed through the separation by buoyancy may be subjected to the leaching separation such that the substrate and the active material layer are separated. The separation method of the present disclosure facilitates the subsequent leaching process, and the water bath after separation by buoyancy can be directly used for the leaching separation, which can greatly reduce the cost of leaching separation. When the leaching process is performed, an appropriate amount of the leaching agent may be added to the leachate so as to complete the leaching process.

In the present disclosure, the organic film may be various organic films, preferably an organic wire film, an organic water-blocking film or an organic encapsulating film.

In the present disclosure, the substrate of the solar cell module may be a stainless steel substrate, a glass-based substrate or a silicon-based substrate.

As an embodiment, the separation method of the organic film of the solar cell module of the present disclosure specifically includes the following steps:
(1) treating the solar cell module by the microwave heat treatment in combination with the water bath ultrasonic treatment, wherein the heat treatment is performed at a temperature of 80 to 300 °C, the duration time for the heat treatment is 5 to 60 min, the water bath ultrasonic treatment is performed under stirring, the stirring is performed a rate of 20 to 150 r/min, the temperature of the water bath is 50 to 100°C, the ultrasonic frequency is 20 to 40 KHz, the stirring direction is changed after each stirring for 10-60 revolutions, and the duration time for the water bath ultrasonic treatment is 10 to 120 min;
(2) after the treatment of the step (1) is completed, performing a separation by buoyancy in water, thereby separating the organic film from the module.

As a further embodiment, the separation method of the organic film of the solar cell module of the present disclosure specifically includes the following steps:
(1) subjecting the solar cell module to the microwave heat treatment at a temperature of 80 to 300 °C for 5 to 60 min;
(2) placing the solar cell module treated in the step (1) in a water bath of 50-100 °C, and subjecting the solar cell module to the ultrasonic treatment for 10 to 120 min under stirring at a stirring rate of 20 to150 r/min, changing the stirring direction after each stirring for 10-60 revolutions, and the ultrasonic frequency is 20-40 KHz;
(3) after the water bath ultrasonic treatment is finished, separating the organic film from the module by buoyancy in water.

The present disclosure uses a microwave heating treatment in combination with a water bath ultrasonic treatment to break the bonding molecules of bonding the organic film and the substrate (such as a steel sheet) without destroying the steel sheet substrate and the active material layer, then uses the ultrasonic water bath to further detach the organic film, and finally use the buoyancy of water to separate the substrate (such as a steel sheet) from the organic film. The substrate (such as a steel sheet) and the organic film are separated by the buoyancy of the water, thus the method of the present disclosure is easy to achieve industrial batch disposal, while eliminating the need for manual splitting one by one. The organic film of the present disclosure is substantially intact, facilitating a subsequent recovery.

The present disclosure has the following beneficial effects:
The present disclosure uses the microwave heat treatment in combination with the water bath ultrasonic treatment to separate the organic film of the solar cell module, so that a stripping rate of the solar cell module reaches 97% or more, and the organic film after detachment does not adhere to the active material, the active material layer remains intact, the surface is clean and has no gelatin spots, and a loss rate is equal to or less than 1%, and thus the method is efficient, convenient, and easy to industrialize, and has broad application prospects.

The present disclosure is further described below with reference to the examples and comparative examples, but the present disclosure is by no means limited to these examples.

### Example 1

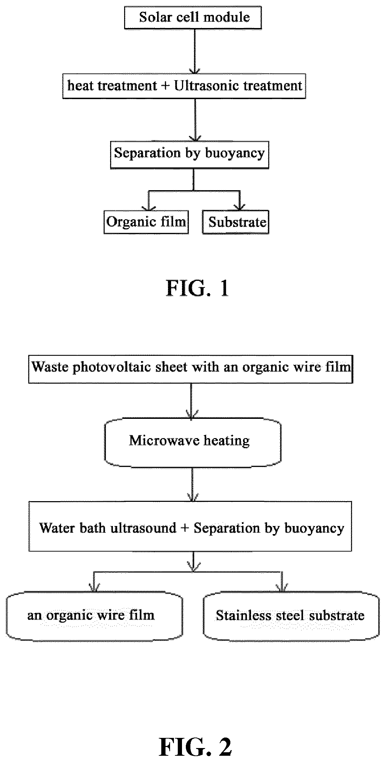

In this example, the organic film of the solar cell module with the stainless steel as the substrate is separated by the following method, which has a specific workflow as shown in FIG. 1, in which the method specifically includes the following steps:
(1) Microwave heat treatment: placing 10 kg of copper indium gallium selenide waste photovoltaic sheet with an organic wire film in an industrial microwave oven for heating, wherein the temperature is maintained at 180 °C for 15 min;
(2) Water bath ultrasonic treatment: preparing a stirring tank with a heating means and a volume of 30 L, adding 25 L of water in advance, and heating to a constant temperature of 95 °C; placing the waste photovoltaic sheet heated in the microwave oven in the step (1) in the stirring tank under stirring, while turning on the ultrasonic device, wherein the stirring rate is 60 r/min, the stirring direction is changed every 10 revolutions, the frequency of the ultrasonic treatment is 30 KHz, and the treatment is continued for 30 min;
(3) Separation by buoyancy: after the water bath ultrasonic treatment is completed, performing the separation by buoyancy in water, such that the organic wire film floats on the surface of the water, and the remaining part of the copper indium gallium selenide stainless steel sheet module sinks to the bottom of the tank, and then removing the organic wire film from the water by a colander or a hanging basket, thereby achieving separation of the organic wire film.

### Example 2

In this example, the organic film of the solar cell module with the stainless steel as the substrate is separated by the following method, in which the method specifically includes the following steps:
(1) Microwave heat treatment: placing 10 kg of copper indium gallium selenide waste photovoltaic sheet with an organic wire film in an industrial microwave oven for heating, wherein the temperature is maintained at 100 °C for 25 min;
(2) Water bath ultrasonic treatment: preparing a stirring tank with a heating means and a volume of 30 L, adding 25 L of water in advance, and heating to a constant temperature of 80 °C; placing the waste photovoltaic sheet heated in the microwave oven in the step (1) in the stirring tank under stirring, while turning on the ultrasonic device, wherein the stirring rate is 80 r/min, the stirring direction is changed every 50 revolutions, the frequency of the ultrasonic treatment is 25 KHz, and the treatment is continued for 40 min;
(3) Separation by buoyancy: after the water bath ultrasonic treatment is completed, performing the separation by buoyancy in water, such that the organic wire film floats on the surface of the water, and the remaining part of the copper indium gallium selenide stainless steel sheet module sinks to the bottom of the tank, and then removing the organic wire film from the water by a colander or a hanging basket, thereby achieving separation of the organic wire film.

### Example 3

In this example, the organic film of the solar cell module with the stainless steel as the substrate is separated by the following method, in which the method specifically includes the following steps:
(1) Microwave heat treatment: placing 10 kg of copper indium gallium selenide waste photovoltaic sheet with an organic wire film in an industrial microwave oven for heating, wherein the temperature is maintained at 150 °C for 10 min;
(2) Water bath ultrasonic treatment: preparing a stirring tank with a heating means and a volume of 30 L, adding 25 L of water in advance, and heating to a constant temperature of 70 °C; placing the waste photovoltaic sheet heated in the microwave oven in the step (1) in the stirring tank under stirring, while turning on the ultrasonic device, wherein the stirring rate is 100 r/min, the stirring direction is changed every 60 revolutions, the frequency of the ultrasonic treatment is 35 KHz, and the treatment is continued for 60 min;
(3) Separation by buoyancy: after the water bath ultrasonic treatment is completed, performing the separation by buoyancy in water, such that the organic wire film floats on the surface of the water, and the remaining part of the copper indium gallium selenide stainless steel sheet module sinks to the bottom of the tank, and then removing the organic wire film from the water by a colander or a hanging basket, thereby achieving separation of the organic wire film.

### Example 4

In this example, the organic film of the solar cell module with the stainless steel as the substrate is separated by the following method, in which the method specifically includes the following steps:
(1) Microwave heat treatment: placing 10 kg of copper indium gallium selenide waste photovoltaic sheet with an organic wire film in an industrial microwave oven for heating, wherein the temperature is maintained at 120 °C for 20 min;
(2) Water bath ultrasonic treatment: preparing a stirring tank with a heating means and a volume of 30 L, adding 25 L of water in advance, and heating to a constant temperature of 100 °C; placing the waste photovoltaic sheet heated in the microwave oven in the step (1) in the stirring tank under stirring, while turning on the ultrasonic device, wherein the stirring rate is 20 r/min, the stirring direction is changed every 20 revolutions, the frequency of the ultrasonic treatment is 20 KHz, and the treatment is continued for 50 min;
(3) Separation by buoyancy: after the water bath ultrasonic treatment is completed, performing the separation by buoyancy in water, such that the organic wire film floats on the surface of the water, and the remaining part of the copper indium gallium selenide stainless steel sheet module sinks to the bottom of the tank, and then removing the organic wire film from the water by a colander or a hanging basket, thereby achieving separation of the organic wire film.

### Example 5

In this example, the organic film of the solar cell module with the stainless steel as the substrate is separated by the following method, in which the method specifically includes the following steps:
(1) Microwave heat treatment: placing 10 kg of copper indium gallium selenide waste photovoltaic sheet with an organic wire film in an industrial microwave oven for heating, wherein the temperature is maintained at 160 °C for 5 min;
(2) Water bath ultrasonic treatment: preparing a stirring tank with a heating means and a volume of 30 L, adding 25 L of water in advance, and heating to a constant temperature of 60 °C; placing the waste photovoltaic sheet heated in the microwave oven in the step (1) in the stirring tank under stirring, while turning on the ultrasonic device, wherein the stirring rate is 150 r/min, the stirring direction is changed every 60 revolutions, the frequency of the ultrasonic treatment is 40 KHz, and the treatment is continued for 80 min;
(3) Separation by buoyancy: after the water bath ultrasonic treatment is completed, performing the separation by buoyancy in water, such that the organic wire film floats on the surface of the water, and the remaining part of the copper indium gallium selenide stainless steel sheet module sinks to the bottom of the tank, and then removing the organic wire film from the water by a colander or a hanging basket, thereby achieving separation of the organic wire film.

### Example 6

In this example, the organic film of the solar cell module with the stainless steel as the substrate is separated by the following method, in which the method specifically includes the following steps:
(1) Microwave heat treatment: placing 10 kg of copper indium gallium selenide waste photovoltaic sheet with an organic encapsulating film in an industrial microwave oven for heating, wherein the temperature is maintained at 80 °C for 60 min;
(2) Water bath ultrasonic treatment: preparing a stirring tank with a heating means and a volume of 30 L, adding 25 L of water in advance, and heating to a constant temperature of 60 °C; placing the waste photovoltaic sheet heated in the microwave oven in the step (1) in the stirring tank under stirring, while turning on the ultrasonic device, wherein the stirring rate is 150 r/min, the stirring direction is changed every 60 revolutions, the frequency of the ultrasonic treatment is 30 KHz, and the treatment is continued for 80 min;
(3) Separation by buoyancy: after the water bath ultrasonic treatment is completed, performing the separation by buoyancy in water, such that the organic encapsulating film floats on the surface of the water, and the remaining part of the copper indium gallium selenide stainless steel sheet module sinks to the bottom of the tank, and then removing the organic encapsulating film from the water by a colander or a hanging basket, thereby achieving separation of the organic encapsulating film.

### Example 7

In this example, the organic film of the solar cell module with the stainless steel as the substrate is separated by the following method, in which the method specifically includes the following steps:
(1) Microwave heat treatment: placing 10 kg of copper indium gallium selenide waste photovoltaic sheet with an organic water-blocking film in an industrial microwave oven for heating, wherein the temperature is maintained at 180 °C for 5 min;
(2) Water bath ultrasonic treatment: preparing a stirring tank with a heating means and a volume of 30 L, adding 25 L of water in advance, and heating to a constant temperature of 60 °C; placing the waste photovoltaic sheet heated in the microwave oven in the step (1) in the stirring tank under stirring, while turning on the ultrasonic device, wherein the stirring rate is 150 r/min, the stirring direction is changed every 60 revolutions, the frequency of the ultrasonic treatment is 30 KHz, and the treatment is continued for 80 min;
(3) Separation by buoyancy: after the water bath ultrasonic treatment is completed, performing the separation by buoyancy in water, such that the organic water-blocking film floats on the surface of the water, and the remaining part of the copper indium gallium selenide stainless steel sheet module sinks to the bottom of the tank, and then removing the organic water-blocking film from the water by a colander or a hanging basket, thereby achieving separation of the organic water-blocking film.

### Example 8

In this example, the organic film of the solar cell module with the stainless steel as the substrate is separated by the following method, in which the method specifically includes the following steps:
(1) Microwave heat treatment: placing 10 kg of gallium arsenide waste photovoltaic sheet with an organic water-blocking film in an industrial microwave oven for heating, wherein the temperature is maintained at 160 °C for 5 min;
(2) Water bath ultrasonic treatment: preparing a stirring tank with a heating means and a volume of 30 L, adding 25 L of water in advance, and heating to a constant temperature of 50 °C; placing the waste photovoltaic sheet heated in the microwave oven in the step (1) in the stirring tank under stirring, while turning on the ultrasonic device, wherein the stirring rate is 150 r/min, the stirring direction is changed every 60 revolutions, the frequency of the ultrasonic treatment is 30 KHz, and the treatment is continued for 80 min;
(3) Separation by buoyancy: after the water bath ultrasonic treatment is completed, performing the separation by buoyancy in water, such that the organic water-blocking film floats on the surface of the water, and the part of the stainless steel sheet module sinks from which the organic water-blocking film is removed sinks to the bottom of the tank, and then removing the organic water-blocking film from the water by a colander or a hanging basket, thereby achieving separation of the organic water-blocking film.

### Example 9

In this example, the organic film of the solar cell module with the stainless steel as the substrate is separated by the following method, in which the method specifically includes the following steps:
(1) Water bath ultrasonic treatment: preparing a stirring tank with a heating means and a volume of 30 L, adding 25 L of water in advance, and heating to a constant temperature of 95 °C; placing 10 kg of gallium arsenide waste photovoltaic sheet with an organic water-blocking film in the stirring tank under stirring, while turning on the ultrasonic device, wherein the stirring rate is 60 r/min, the stirring direction is changed every 10 revolutions, the frequency of the ultrasonic treatment is 30 KHz, and the treatment is continued for 60 min;
(2) Microwave heat treatment: placing the waste photovoltaic sheet treated in the step (1) in an industrial microwave oven for heating, wherein the temperature is maintained at 180 °C for 15 min;
(3) Separation by buoyancy: after the microwave heat treatment is completed, placing the waste photovoltaic chips in the water bath with a constant temperature of 95°C, performing the separation by buoyancy in water, such that the organic water-blocking film floats on the surface of the water, and the part of the stainless steel sheet module from which the organic water blocking film is removed sinks to the bottom of the tank, and then removing the organic water-blocking film from the water by a colander or a hanging basket, thereby achieving separation of the organic water-blocking film.

### Comparative example 1

The only difference from Example 1 is that the temperature of the microwave heat treatment is 50 °C.

### Comparative example 2

The only difference from Example 1 is that the temperature of the microwave heat treatment is 500 °C.

### Comparative example 3

The only difference from Example 1 is that the frequency of the ultrasonic treatment is 8 KHz.

### Comparative example 4

The only difference from Example 1 is that the frequency of the ultrasonic treatment is 55 KHz.

The separation effects of the separation methods and the case of the isolated products obtained in Examples 1-9 and Comparative Examples 1-4 are summarized in Table 1 below (wherein the stripping rate refers to the percentage of the organic film removed from the solar cell module).

**Table 1**

| | stripping rate | Adhesion of organic film to active layer | Integrity of active material layer | Loss rate of active material layer |
|---|---|---|---|---|
| Example 1 | 98% | few | integrity | 0.4% |
| Example 2 | 99% | few | integrity | 0.5% |
| Example 3 | 98.5% | few | integrity | 0.6% |
| Example 4 | 97.8% | few | integrity | 0.3% |
| Example 5 | 99.2% | few | integrity | 0.4% |
| Example 6 | 97% | few | integrity | 0.6% |
| Example 7 | 97.5% | few | integrity | 1% |
| Example 8 | 98% | few | integrity | 0.5% |
| Example 9 | 97% | few | integrity | 0.6% |
| Comparative example 1 | 81% | a certain degree of adhesion | integrity | 0.5% |
| Comparative example 2 | 76% | more | incomplete | 15% |
| Comparative example 3 | 93% | more | integrity | 0.2% |
| Comparative example 4 | 98.5% | few | incomplete | 5% |

In Table 1, the stripping rate refers to a ratio of a number of the chips that has stripped successfully to a total number of chips as observed by the naked eye; the loss rate of the active material layer = a weight of the organic film lost in the process / a total weight of the organic film, wherein a weight of the organic film lost in the process is a total weight of the organic film (obtained by the product parameters) minus a weight of a organic film weighed after it has been dried .

It can be seen from the data of Table 1 that by adopting the separation method of the present disclosure, the stripping rate of the wast solar cell module reaches 97% or more, and the organic film after detachment does not adhere to the active material, the active material layer remains intact, the surface is clean and has no gelatin spots, and the loss rate is is equal to or less than 1%.

### Example 10

In this example, the organic film of the solar cell module with the stainless steel as the substrate is separated by the following method, in which the method specifically includes the following steps:
(1) Microwave heat treatment: placing 10 kg of copper indium gallium selenide waste photovoltaic sheet with an organic wire film in an industrial microwave oven for heating, wherein the temperature is maintained at 180 °C for 15 min;
(2) Water bath ultrasonic treatment: preparing a stirring tank with a heating means and a volume of 30 L, adding 25 L of water in advance, and heating to a constant temperature of 95 °C; placing the waste photovoltaic sheet heated in the microwave oven in the step (1) in the stirring tank under stirring, while turning on the ultrasonic device, wherein the stirring rate is 60 r/min, the stirring direction is changed every 10 revolutions, the frequency of the ultrasonic treatment is 30 KHz, and the treatment is continued for 30 min;
(3) Separation by buoyancy: after the water bath ultrasonic treatment is completed, performing the separation by buoyancy in water, such that the organic wire film floats on the surface of the water, and the remaining part of the copper indium gallium selenide stainless steel sheet module sinks to the bottom of the tank, and then removing the organic wire film from the water by a colander or a hanging basket, thereby achieving separation of the organic wire film;
(4) recycling the copper indium gallium selenide solar cell module from which the organic wire film is detached, including:
   A. Passivation treatment:
      An aqueous solution of hydrogen peroxide with a concentration of 3.5 mass% is formulated, the copper indium gallium selenide solar cell module from which the resin film has been removed is immersed in the 50 L aqueous solution of hydrogen peroxide, a passivation treatment is performed on the copper indium gallium selenide solar cell at a temperature of 40 °C for a duration time of 1 hour. The stainless steel on the surface of the stainless steel substrate is passivated to form a passivation layer, obtaining a mixture of a copper indium gallium selenide solar cell in which the surface of the stainless steel substrate are passivated and a hydrogen peroxide solution is obtained. The main component of the passivation layer is triiron tetroxide.
   B. Step by step leaching:
      First leaching:
      50 L of 20% by mass sulfuric acid solution is slowly added to the mixture of a copper indium gallium selenide solar cell in which the surface of the stainless steel substrate are passivated and a hydrogen peroxide solution. Then, the mixture is mixed evenly under stirring. After mixing, the copper indium gallium selenide solar cell in which the surface of the stainless steel substrate is passivated is immersed in the mixed liquid, wherein the mass percentage of sulfuric acid in the mixed solution is 10%, and the temperature is 40 °C. During the leaching process, a slight oscillation was given, and the leaching was continued for 1 hour. At this time, the active material layer was detached from the stainless steel substrate whose surface was a passivation layer. The active material in the active material layer enters the mixed liquid mostly in the form of powder or debris, the passivated stainless steel substrate is not destroyed, and the passivated stainless steel substrate is removed with a colander.

The passivation layer does not react during the first leaching process, and the surface portion of the active material layer reacts. The copper indium gallium selenide in the active material layer in this example reacts with hydrogen peroxide under acidic condition, wherein the copper indium gallium selenide, hydrogen peroxide, and hydrogen ions are reacted to form Cu³⁺, In³⁺, Ga³⁺, SeO₃²⁻, SeO₄²⁻, and H₂O. The active material layer in this example further includes zinc oxide and cadmium sulfide, wherein zinc oxide is reacted with hydrogen ions to form Zn²⁺ and water, and cadmium sulfide is reacted with hydrogen peroxide to form Cd²⁺, SO₄²⁻ and water. Since the immersion temperature is low, the above reactions are slow, and only the surface portion of the active material layer is reacted.

### Second leaching:

The mixture in which the active material layer was immersed was heated to 95 °C and the leaching process is stopped after 1 hour. At this time, the mixed solution in which the active material layer is immersed becomes clear, and the powder or debris of the active material layer is completely dissolved in the mixed solution, the total solution in which the active material is dissolved is obtained, and after cooling, it can be sent to a subsequent wet process for recycling.

After the second leaching and heating, the above reactions are advanced and the active material layer is completely dissolved.

Table 1 below shows the concentration and a leaching rate of each element in the total solution in which the active material was dissolved after the second leaching. The concentration of each element in the total solution was detected by atomic absorption. According to the leaching concentration of copper, indium, gallium and selenium in the solution and the content of each element in the chip, the leaching rate can be calculated after conversion. It can be seen from Table 1 that the concentration of iron in the solution is very small, only 70 ppm, and the separation method in this example hardly caused corrosion damage to the stainless steel substrate. The leaching rates of copper, indium, gallium and selenium all reached 99% or more, and almost all were leached into the solution.

| element | In | Ga | Se | Fe |
|---|---|---|---|---|
| concentration/ppm | 360 | 210 | 945 | 70 |
| leaching rate | 99.7% | 99.6% | 99.5% | 0.1% |

### Example 11

In this example, the organic film of the solar cell module with the stainless steel as the substrate is separated by the following method, in which the method specifically includes the following steps:
(1) Microwave heat treatment: placing 10 kg of copper indium gallium selenide waste photovoltaic sheet with an organic wire film in an industrial microwave oven for heating, wherein the temperature is maintained at 160 °C for 5 min;
(2) Water bath ultrasonic treatment: preparing a stirring tank with a heating means and a volume of 30 L, adding 25 L of water in advance, then adding 1.5 kg of sodium hydroxide and 5 kg of sodium sulfate to dissolve them by stirring, and heating to a constant temperature of 60 °C; placing the waste photovoltaic sheet heated in the microwave oven in the step (1) in the stirring tank under stirring, while turning on the ultrasonic device, wherein the stirring rate is 150 r/min, the stirring direction is changed every 60 revolutions, the frequency of the ultrasonic treatment is 40 KHz, and the treatment is continued for 5 min;
(3) Separation by buoyancy: after the water bath ultrasonic treatment is completed, performing the separation by buoyancy in water, such that the organic wire film floats on the surface of the water, and the remaining part of the copper indium gallium selenide stainless steel sheet module sinks to the bottom of the tank, and then removing the organic wire film from the water by a colander or a hanging basket, thereby achieving separation of the organic wire film.

### Example 12

In this example, the organic film of the solar cell module with the stainless steel as the substrate is separated by the following method, in which the method specifically includes the following steps:
(1) Microwave heat treatment: placing 10 kg of copper indium gallium selenide waste photovoltaic sheet with an organic encapsulating film in an industrial microwave oven for heating, wherein the temperature is maintained at 80 °C for 60 min;
(2) Water bath ultrasonic treatment: preparing a stirring tank with a heating means and a volume of 30 L, adding 25 L of water in advance, then adding 0.5 kg of potassium hydroxide and 8 kg of sodium sulfate to dissolve them by stirring, and heating to a constant temperature of 60 °C; placing the waste photovoltaic sheet heated in the microwave oven in the step (1) in the stirring tank under stirring, while turning on the ultrasonic device, wherein the stirring rate is 150 r/min, the stirring direction is changed every 60 revolutions, the frequency of the ultrasonic treatment is 30 KHz, and the treatment is continued for 8 min;
(3) Separation by buoyancy: after the water bath ultrasonic treatment is completed, performing the separation by buoyancy in water, such that the organic encapsulating film floats on the surface of the water, and the remaining part of the copper indium gallium selenide stainless steel sheet module sinks to the bottom of the tank, and then removing the organic encapsulating film from the water by a colander or a hanging basket, thereby achieving separation of the organic encapsulating film.

**Table 2**

| | stripping rate | Adhesion of organic film to active layer | Integrity of active material layer | Loss rate of active material layer | Time for water bath ultrasonic treatment (min) |
|---|---|---|---|---|---|
| Example 11 | 99.6% | few | integrity | 0.5% | 5 |
| Example 12 | 99.7% | few | integrity | 0.6% | 8 |

The data in Table 2 above shows that by adding a chemical reagent such as an inorganic salt to the water bath, the stripping rate can be improved and the duration time for water bath treatment can be shortened at the same time. Specifically, the duration time for water bath treatment of Examples 11 and 12 were only less than 10% of that of the examples in which no chemical agent such as an inorganic salt was added.

The present disclosure illustrates the process of the present disclosure by the above-described examples, but the present disclosure is not limited to the above process steps, that is, it does not mean that the present disclosure must rely on the above process steps to be implemented. It should be understood by those skilled in the art that any modifications of the present disclosure, equivalent substitutions of the materials selected for the present disclosure, and the addition of the auxiliary components, the selection of the specific manners, and the like, are all within the scope of the disclosure and the scope of the disclosure.

## Claims

1. A method for separation of an organic film from a solar cell module, **characterized in that** the method includes the following steps:
treating the solar cell module by a heat treatment in combination with a ultrasonic treatment; and
performing separation of the treated solar cell module by buoyancy, thereby achieving separation of the organic film from the solar cell module.

2. The separation method according to claim 1, **characterized in that** the heat treatment is performed at a temperature of 80 to 300 °C, preferably 100 to 180 °C;
alternatively, a duration time for the heat treatment is 5 to 60 min, preferably 15 to 40 min;
alternatively, a ultrasonic frequency of the ultrasonic treatment is 20 to 40 KHz;
alternatively, a duration time for the ultrasonic treatment is 10 to 120 min.

3. The separation method according to claim 1 or 2, **characterized in that** the heat treatment is a microwave heat treatment, a muffle furnace heat treatment, an induction cooker heat treatment or an electric furnace heat treatment, preferably a microwave heat treatment;
alternatively, the ultrasonic treatment is a water bath ultrasonic treatment, preferably the temperature of water bath during the water bath ultrasonic treatment is 50 to 100 °C, further preferably the water bath ultrasonic treatment is performed with stirring, and the stirring is performed at a rate of 20 to 150 r/min, alternatively, a direction of the stirring is changed after each stirring for 10-60 revolutions, alternatively, a duration time for the water bath ultrasonic treatment is 10 to 120 min, alternatively, the separation by buoyancy is a separation by buoyancy performed in water;
alternatively, the separation method comprises the steps of: treating the solar cell module by the microwave heat treatment in combination with the water bath ultrasonic treatment, and separating the treated solar cell module by buoyancy, thereby achieving separation of the organic film from the module;
alternatively, the microwave heat treatment in combination with the water bath ultrasonic treatment is performed by first performing the microwave heat treatment of the solar cell module, and then performing the water bath ultrasonic treatment of the solar cell module; or first performing the water bath ultrasonic treatment of the solar cell module, and then performing the microwave heat treatment of the solar cell module; preferably, by first performing the microwave heat treatment of the solar cell module, and then performing the water bath ultrasonic treatment of the solar cell module.

4. The separation method according to any one of claims 1 to 3, **characterized in that** the organic film is an organic wire film, an organic water-blocking film or an organic encapsulating film; and
alternatively, a substrate of the solar cell module is a stainless steel substrate, a glass-based substrate or a silicon-based substrate.

5. The separation method according to any one of claims 1 to 3, **characterized in that** the separation method includes the following steps:
(1) treating the solar cell module by the microwave heat treatment in combination with the water bath ultrasonic treatment, wherein the microwave heat treatment is performed at a temperature of 80 to 300 °C, the duration time for the microwave heat treatment is 5 to 60 min, the water bath ultrasonic treatment is performed with stirring, the stirring is performed at rate of 20 to 150 r/min, the temperature of water bath is 50 to 100°C, the ultrasonic frequency is 20 to 40 KHz, the direction of the stirring is changed after each stirring for 10-60 revolutions, the during time for the water bath ultrasonic treatment is 10 to 120 min;
(2) after the treatment of the step (1) is completed, performing separation by buoyancy in water, thereby separating the organic film from the module.

6. The separation method according to any one of claims 1 to 5, **characterized in that** the separation method includes the following steps:
(1) subjecting the solar cell module to the microwave heat treatment at a temperature of 80 to 300 °C for 5 to 60 min;
(2) placing the solar cell module treated in the step (1) in a water bath of 50-100 °C while keeping warm, subjecting the solar cell module to the ultrasonic treatment for 10 to 120 min under stirring at a stirring rate of 20 to 150 r/min, and changing the direction of the stirring after each stirring for 10-60 revolutions, wherein the ultrasonic frequency is 20-40 KHz;
(3) after the water bath ultrasonic treatment is finished, separating the organic film from the module by buoyancy in water.

7. The separation method according to any one of claims 1 to 6, **characterized in that** an inorganic salt is added during the ultrasonic treatment.

8. The separation method according to claim 7, **characterized in that** the inorganic salt is selected from one or more of sodium hydroxide, potassium hydroxide, calcium hydroxide, calcium oxide, magnesium hydroxide, magnesium oxide, sodium carbonate, potassium carbonate, sodium sulfate, potassium sulfate, sodium chloride, potassium chloride, basic zinc carbonate, and sodium hypochlorite.

9. A recycling method of a solar cell module, **characterized in that** the recycling method includes the separation method according to any one of claims 1-8.

10. The recycling method according to claim 9, **characterized in that** the solar cell module is a flexible solar cell module.

11. The recycling method according to claim 9 or 10, **characterized in that** the recycling method further includes: after separating the organic film from the solar cell module, subjecting the remaining portion of the module to a leaching separation such that a substrate of the solar cell module is separated from a active material layer.

12. The recycling method according to claim 11, **characterized in that** the ultrasonic treatment was performed using the water bath ultrasonic treatment, then separation by buoyancy was performed using the water in the water bath, and the leaching separation was performed directly using the water bath solution after the separation by buoyancy.

13. The recycling method according to claim 12, **characterized in that** a leaching agent is added to the leachate during the leaching separation, and
alternatively, the leaching agent is a mixture of an acidic substance and a surface treatment agent.

14. The recycling method according to claim 13, **characterized in that** the acidic substance is selected from any one or more of sulfuric acid, hydrochloric acid, and nitric acid.

15. The recycling method according to claim 13, **characterized in that** the surface treatment agent is selected from any one or more of hydrogen peroxide, sodium hypochlorite, sodium peroxide, ozone, sodium nitrite, sodium phosphate, and a corrosion inhibitor Lan826.
